# EUROPEAN PATENT SPECIFICATION

(11) **EP 0 381 237 B1**
(45) Date of publication and mention of the grant of the patent: **01.09.1999**
(21) Application number: 90102104.8
(22) Date of filing: 02.02.1990
(51) Int. Cl.: H01L 27/092, H01L 29/78

(54) **Integrated semiconductor circuit with p and n channel MOS transistors**
Integrierte Halbleiterschaltung mit P- und N-Kanal-MOS-Transistoren
Circuit semi-conducteur intégré avec transistors M.O.S. à canaux P et N

(30) Priority: 03.02.1989 JP 2398589
(43) Date of publication of application: 08.08.1990
(73) Proprietor: KABUSHIKI KAISHA TOSHIBA, Kawasaki-shi, Kanagawa-ken 210-8572 (JP)
(72) Inventor: Saitoh, Kouji, Yokohama-shi, Kanagawa-ken (JP); Saeki, Yukihiro, Yokohama-shi, Kanagawa-ken (JP)
(74) Representative: Lehn, Werner, Dipl.-Ing.

(56) References cited:
- EP-A- 0 182 121
- PATENT ABSTRACTS OF JAPAN, unexamined applications, E field, vol. 9, no. 15, January 22, 1985 THE PATENT OFFICE JAPANESE GOVERNMENT page 102 E 291

## Description

The present invention relates to a semiconductor circuit formed within a semiconductor substrate comprising:-
a first region of said semiconductor substrate where N-channel and P-channel first MOS transistors are formed, said first MOS transistors having source, gate and drain regions, and a first power source for said first transistors being arranged to provide a first potential difference between a first potential (Vdd) and ground potential;
a second region of said semiconductor substrate where N-channel and P-channel second MOS transistors are formed adjacent to said first region, and have drain regions, channel regions and source regions, and a second power source for said second transistors being arranged to provide a second potential difference between a second potential (Vpp) and ground potential, said first and second potential differences being unequal; and
the source, gate and drain regions of the first and second MOS transistors being arranged in a row along the first and second regions.

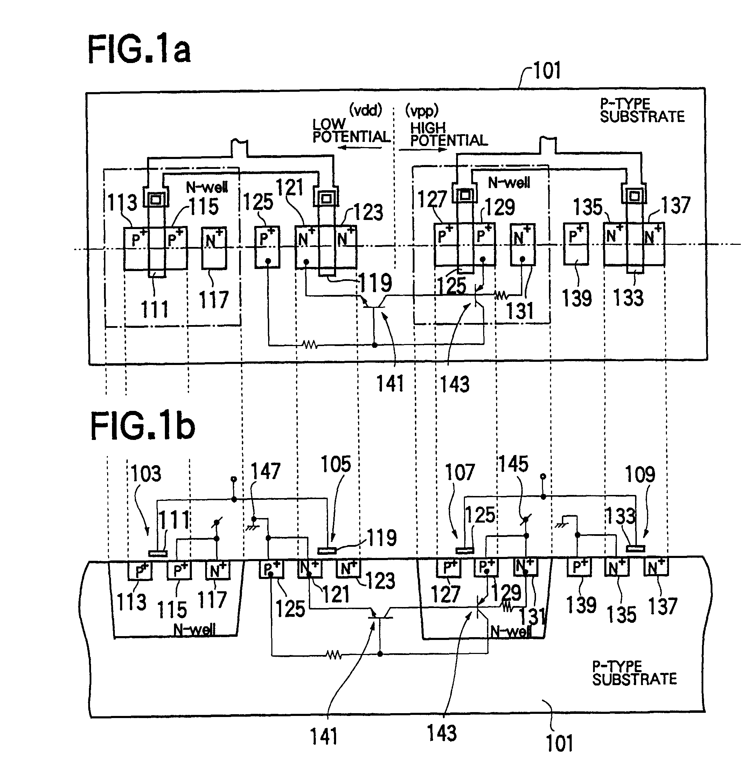

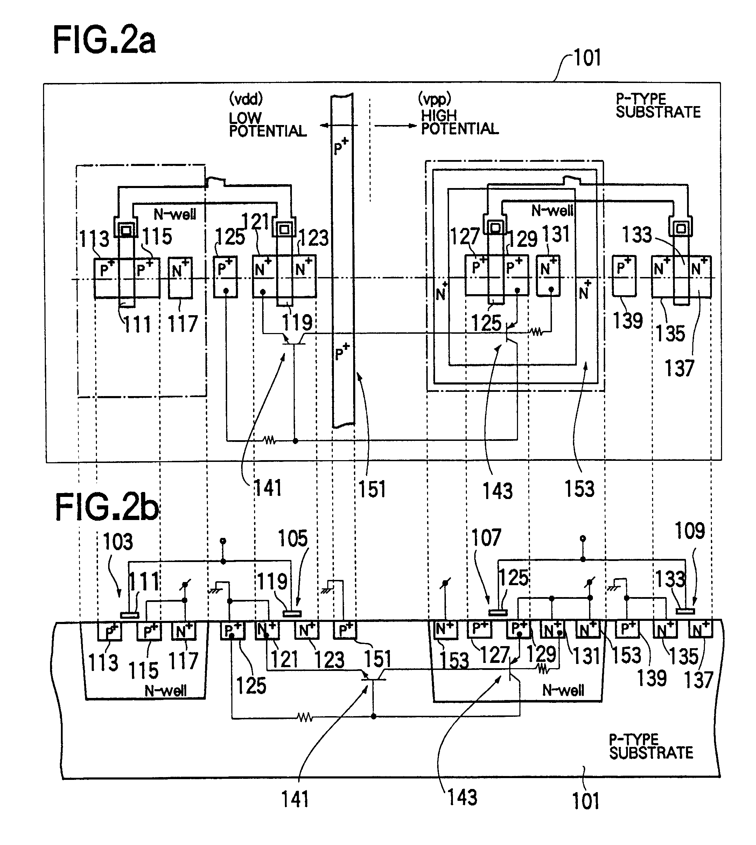

Conventional circuits of this type will be described hereinafter with reference to Figures 1a, 1b, 2a and 2b.

Further semiconductor integrated circuits are described in EP-A-0 182 121, and JP-A-59 163 837.

EP-A-0 245 515 describes a semiconductor device designed to prevent the injection of minority carriers into a substrate when the potential applied to the device undergoes changes due to noise or the like.

Latch-up is a particular phenomenon generally induced between CMOS circuits when parasitic transistors formed in parasitic NPN and PNP regions between adjacent transistor elements of the CMOS circuits are triggered and operated as a thyristor. The thyristor causes an uncontrollable excess current to continuously flow from a power source terminal to a ground terminal and to destroy the transistor elements.

The latch-up phenomenon is triggered when a MOS transistor adjacent to the thyristor formed by the parasitic transistors is turned on. At this moment, hot carriers generated around a drain of the MOS transistor flow to a substrate to upset a normal substrate voltage.

The latch-up phenomenon will be explained in detail with reference to Figs. 1 and 2.

Figure 1a is a plan view showing a conventional semiconductor circuit for explaining the latch-up phenomenon, and Fig. 1b is a sectional view thereof.

As shown in the Figures, the conventional semiconductor circuit comprises a P-type substrate 101 on which a low-potential system (Vdd) and a high-potential system (Vpp) are formed adjacent to each other. The low-potential system (Vdd) comprises a first P-channel MOS transistor 103 and a first N-channel MOS transistor 105 that are complementarily connected to each other. The high-potential system (Vpp) comprises a second P-channel MOS transistor 107 and a second N-channel MOS transistor 109 that are complementarily connected to each other. Namely, on each side of a boundary between the low-potential system (Vdd) and high high-potential system (Vpp), the first N-channel MOS transistor 105 and second P-channel MOS transistor 107 that have different channel polarities are disposed adjacent to each other.

The first P-channel MOS transistor 103 has a gate electrode 111, a P⁺ drain region 113, a P⁺ source region 115, and an N⁺ region 117 for supplying the Vdd-potential to an N-type well. The first N-channel MOS transistor 105 has a gate electrode 119, an N⁺ source region 121, an N⁺ drain region 123, and a P⁺ region 125 for supplying the ground-potential to the P-type substrate 101.

Similarly, the second P-channel MOS transistor 107 has a gate electrode 125, P⁺ drain and source regions 127 and 129, and an N⁺ region 131 for supplying the Vpp-potential to the N-type well. The second N-channel MOS transistor 109 has a gate electrode 133, N⁺ source and drain regions 135 and 137, and a P⁺ region 139 for supplying the ground-potential to the P-type substrate 101.

In CMOS semiconductor circuit, a parasitic NPN transistor 141 and a parasitic PNP transistor 143 are formed.

To normally operate the above semiconductor circuit (CMOS IC), potentials of the P-type substrate 101 and an N-type well must be kept stably at a ground level and a level of Vpp, respectively.

If an instantaneous trigger current flows in the substrate 101 around the parasitic NPN transistor 141, the potential of the P-type substrate is increased from the ground level to turn on the parasitic NPN transistor 141, thereby turning on the parasitic PNP transistor 143. Then, the parasitic transistors 141 and 143 act as a thyristor to cause the latch-up phenomenon which causes an uncontrollable excess current to continuously flow from a power source terminal 145 to a grounding terminal 147.

If the instantaneous trigger current flows in an N-type well around the parasitic PNP transistor 143, the potential of the N-type well drops from the level of Vpp to turn on the parasitic PNP transistor 143, thereby turning on the parasitic NPN transistor 141. Then, the parasitic transistors 141 and 143 act as a thyristor to cause the latch-up phenomenon which causes an uncontrollable excess current to continuously flow from the power source terminal 145 to the grounding terminal 147.

The trigger current may be generated by an internal factor of the chip. At an instance when another MOS transistor in the vicinity of the parasitic transistors 141 and 143 is turned on, hot carriers are thought to be generated around a drain of the MOS transistor and flow to the substrate and N-type well to produce the trigger current.

The trigger current may also be generated by an external factor of the ship. Generally, a MOS IC chip has a pad directly connected to a protective diode to prevent electrostatic destruction from the outside of the chip. When a voltage exceeding a power source voltage is applied to the pad, the protective diode is turned on to free excessive charges to a substrate or to an N-type well. The freed charges are considered to produce the trigger current of the latch-up phenomenon.

The trigger current generating tendency will be considered for three kinds of power sources, i.e., a grounding, a 5-volt power source Vdd, and a 12.5-volt power source Vpp.

Substantially no latch-up phenomenon occurs between transistors of the Vdd (5 volts) system. The latch-up phenomenon frequently occurs between transistors of the Vpp (12.5 volts) system, or between a transistor of the Vdd (5 volts) system and an adjacent transistor of the Vpp (12.5 volts) system. In the CMOS circuit of Fig. 1, the latch-up phenomenon was explained to occur between the N-channel MOS transistor 105 of the low-potential system (Vdd) and the P-channel MOS transistor 107 of the high-potential system (Vpp).

A known technique of preventing the latch-up phenomenon is to provide a diffusion layer between, for example, a transistor of the Vdd system and a transistor of the Vpp system, to absorb the trigger current.

Figure 2 shows a concrete example of the latch-up preventing technique. This example arranges a diffusion layer as a guard ring for the semiconductor circuit of Fig. 1.

In Fig. 2, a P-type diffusion layer 151 is disposed as guard rings along a boundary between the first N-channel MOS transistor 105 of the low-potential system (Vdd) and the second P-channel MOS transistor 107 of the high-potential system (Vpp). In addition, an N-type diffusion layer 153 is disposed as a guard ring around the N-type well of the second P-channel MOS transistor 107. The diffusion layers 151 and 153 prevent the latch-up phenomenon. Other arrangement of Fig. 2 is the same as the arrangement of Fig. 1, and therefore, like elements are represented with like reference marks to omit their explanations.

The reasons why the P-type diffusion layer 151 and the N-type diffusion layer 153 are disposed are as follows:
(1) To absorb a generated trigger current and free the same outside.
(2) Even if the latch-up phenomenon occurs to flow a collector current to the parasitic NPN transistor 141 or to the parasitic PNP transistor 143, the current is absorbed by the guard rings to cut a positive feedback loop. To absorb latch-up currents on the transistors 105 and 107 separately, it is effective to arrange the two resistive diffusion layers on the Vdd and Vpp systems, respectively.

The diffusion layers, however, enlarge a distance between the first N-channel MOS transistor 105 and the second P-channel MOS transistor 107, thereby increasing a chip area. This is disadvantageous for a circuit integration technique that requires a chip size to be minimized. Although the integration technique of nowadays is capable of minimizing a distance between elements of an integrated circuit, the latch-up phenomenon prevents a close arrangement of transistors of the Vdd and Vpp systems, thereby spoiling the merit of the integration technique.

An object of the present invention is to provide a semiconductor circuit that can greatly reduce a distance between elements of the circuit without causing latch-up.

Another object of the present invention is to provide a semiconductor circuit that can prevent parasitic bipolar transistors from exhibiting undesired thyristor operation, thereby preventing the latch-up phenomenon.

Accordingly, the present invention provides a semiconductor circuit as defined by claim 1.

This and other objects, features and advantages of the present invention will be more apparent from the following detailed description of preferred embodiments in conjunction with the accompany drawings, in which:
Fig. 1 is a schematic view showing a conventional semiconductor circuit that may cause the latch-up phenomenon;
Fig. 2 is a schematic view showing a conventional semiconductor circuit provided with diffusion layers as guard rings for preventing the latch-up phenomenon;
Fig. 3 is a schematic view showing a semiconductor circuit according to a first embodiment of the present invention; and
Fig. 4 is a schematic view showing a semiconductor circuit according to a second embodiment of the present invention.

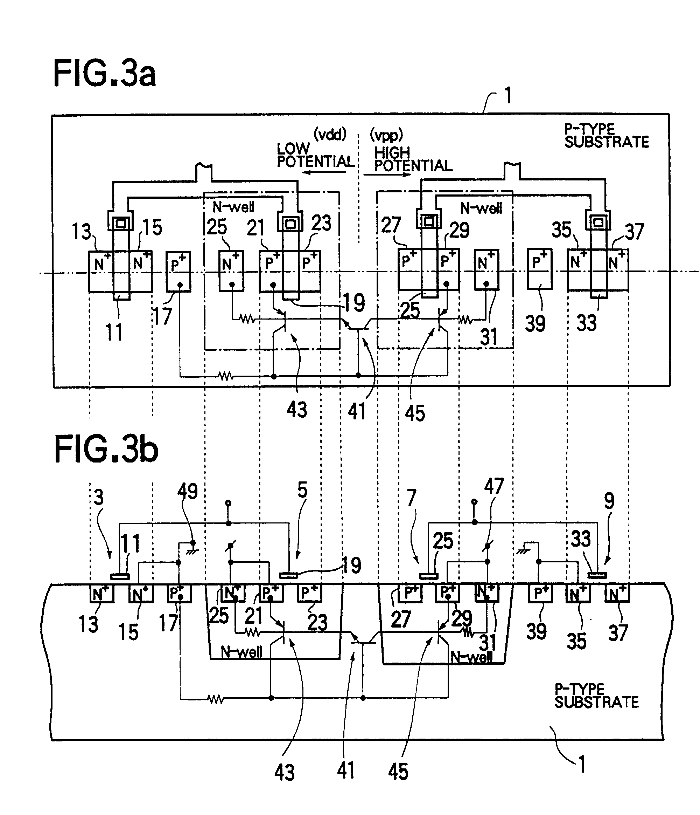

Figure 3a is a plan view showing a semiconductor circuit according to the first embodiment of the present invention, and Fig. 3b is a sectional view thereof.

As shown in the figures, the semiconductor circuit comprises a P-type substrate 1 on which a low-potential system (Vdd) and a high-potential system (Vpp) are formed adjacent to each other. The low-potential system (Vdd) comprises a first N-channel MOS transistor 3 and a first P-channel MOS transistor 5 that are complementarily connected to each other. The high-potential system (Vpp) comprises a second P-channel MOS transistor 7 and a second N-channel MOS transistor 9 that are complementarily connected to each other. Namely, on each side of a boundary between the low-potential system (Vdd) and high-potential system (Vpp), the first P-channel MOS transistor 5 and second P-channel MOS transistor 7 having the same channel polarity are disposed adjacent to each other.

The first N-channel MOS transistor 3 has a gate electrode 11, an N⁺ drain region 13, an N⁺ source region 15, and a P⁺ region 17 for supplying the ground-potential to the P-type substrate 1. The first P-channel MOS transistor 5 has a gate electrode 19, a P⁺ source region 21, a P⁺ drain region 23, and an N⁺ region 25 for supplying the Vdd-potential to an N-type well.

Similarly, the second P-channel MOS transistor 7 has a gate electrode 25, P⁺ drain and source regions 27 and 29, and an N⁺ region 31 for supplying the Vpp-potential to the N-type well. The second N-channel MOS transistor 9 has a gate electrode 33, N⁺ source and drain regions 35 and 37, and a P⁺ region 39 acting for supplying the ground-potential to the P-type substrate 1.

In the above semiconductor circuit, a parasitic NPN transistor 41 and parasitic PNP transistors 43 and 45 are formed.

The parasitic PNP transistors 43 and 45 are connected in a manner similar to the conventional example of Fig. 1. In this embodiment, however, a potential of the N-well region corresponding to an emitter of the parasitic NPN transistor 41 is low (Vdd).

If hot carriers are generated somewhere in the high-potential system (Vpp), the parasitic NPN transistor 41 is turned on only when a potential of the P-type substrate 1 is increased from the ground level to a level of Vdd + Vf (Vf is a diode forward voltage). For example, if Vdd + 5V, then Vdd + Vd = 5 + 0.7 = 5.7V. Usually, the substrate potential does not increase to such an extent by the trigger current, so that the parasitic NPN transistor 41 may not be turned on to demonstrate, with the parasitic PNP transistor 45, a thyristor operation that causes an excess current to flow from a terminal 47 to a terminal 49. Namely, the latch-up phenomenon will not occur. Also with the other parasitic PNP transistor 43, the parasitic NPN transistor 41 will not demonstrate the thyristor operation because it is not turned on as explained above.

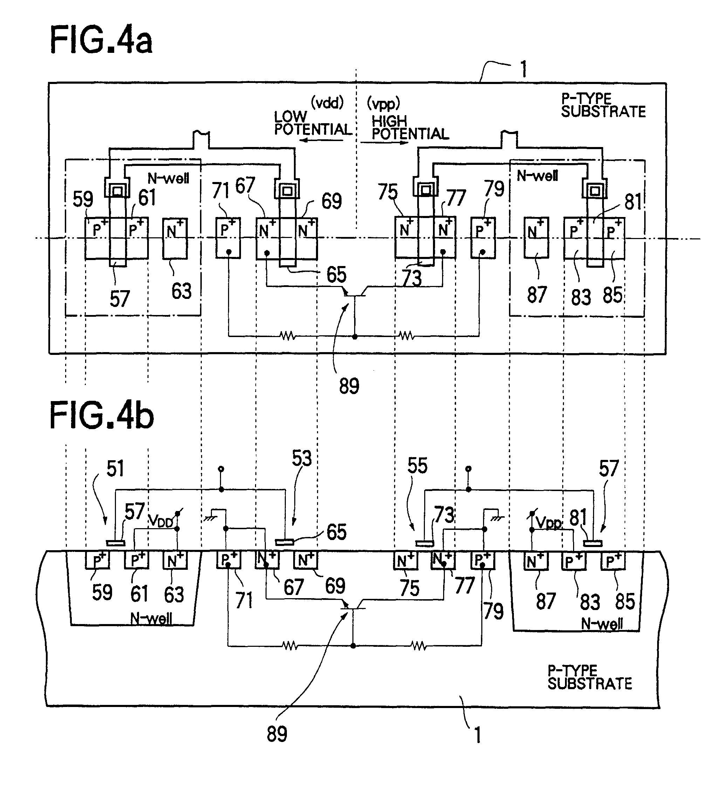

Figure 4 shows a semiconductor circuit according to the second embodiment of the present invention.

As shown in the figure, the semiconductor circuit comprises a P-type substrate 1 on which a low-potential system (Vdd) and a high-potential system (Vpp) are formed adjacent to each other. The low-potential system (Vdd) comprises a first P-channel MOS transistor 51 and a first N-channel MOS transistor 53 that are complementarily connected to each other. The high-potential system (Vpp) comprises a second N-channel MOS transistor 55 and a second P-channel MOS transistor 57 that are complementarily connected to each other. Namely, on each side of a boundary between the low-potential system (Vdd) and high-potential system (Vpp), the first N-channel MOS transistor 53 and second N-channel MOS transistor 55 having the same channel polarity are disposed adjacent to each other.

The first P-channel MOS transistor 51 has a gate electrode 57, a P⁺ drain region 59, a P⁺ source region 61, and an N⁺ region 63 for supplying the Vdd-potential to an N-type well. The first N-channel MOS transistor 53 has a gate electrode 65, an N⁺ source region 67, an N⁺ drain region 69, and a P⁺ region 71 for supplying the ground-potential to the P-type substrate 1.

Similarly, the second N-channel MOS transistor 55 has a gate electrode 73, N⁺ drain and source regions 75 and 77, and a P⁺ region 79 for supplying the ground-potential to the P-type substrate 1. The second P-channel MOS transistor 57 has a gate electrode 81, P⁺ source and drain regions 83 and 85, and an N⁺ region 87 for supplying the Vpp-potential to the N-type well.

In the above semiconductor circuit, a parasitic bipolar NPN transistor 89 is formed.

In this embodiment, the N⁺ diffusion region 77, P-type substrate 1 and N⁺ diffusion region 67 from only one parasitic NPN transistor 89, so that, even if a trigger current flows to increase a potential of the P-type substrate 1, the parasitic NPN transistor 89 may not be turned on to cause a current to flow from the N⁺ region 77 to the N⁺ region 67.

Since the embodiment does not have a parasitic PNP transistor, a thyristor conjunction is not formed to cause the latch-up phenomenon.

Although N-type wells are formed in the above embodiments, P-type wells are also applicable, if potential relations are inverted. Further, a twin well structure employing P-type wells and N-type wells is also applicable.

The foregoing has described a semiconductor circuit in which two MOS transistors having the same channel polarity are arranged adjacent to each other on each side of a boundary between two CMOS circuits of different power source voltages, to prevent the thyristor operation of parasitic bipolar transistors.

More particularly, two MOS transistors having the same channel polarity are arranged on each side of a boundary between a low-potential system and a high-potential system, so that parasitic bipolar transistors formed by the MOS transistors may not perform the thyristor operation. Accordingly, no latch-up phenomenon occurs and, unlike the conventional semiconductor circuit, no latch-up preventive diffusion region is needed.

With this arrangement, a distance between the transistors of the low-potential and high-potential systems can be reduced to a minimum limit allowed by a manufacturing technique. The arrangement can further reduce, therefore, an LSI chip area without causing the latch-up phenomenon.

Various modification will become possible for those skilled in the art after receiving the teachings of the present disclosure without departing from the scope thereof.

## Claims

1. A semiconductor circuit formed within a semiconductor substrate (1) of a first conductivity type (P) and comprising:
a first region of said semiconductor substrate where a pair of complementarily connected first MOS transistors (3, 5;51 ,63) are formed, one (3; 53) of said first MOS transistors being of a second conductivity type (N) and the other (5; 51) of said first MOS transistors being of the first conductivity type and formed in a first well of the second conductivity type in said substrate, said first MOS transistors (3, 5; 51, 53) having gate, source and drain regions (11, 15, 13; 19, 21, 23; 57, 61, 59; 65, 67, 69);
a first power source for said first MOS transistors being arranged to provide a first potential difference between a first potential (Vdd) and ground potential by providing said first potential to said source (21; 61) of the one of said first MOS transistors of the first conductivity type as well as to a first well contact region (25; 63) formed in said first well, and by providing said ground potential to said source (15; 67) of the one of said first MOS transistors of the second conductivity type as well as to a first substrate contact region (17; 71) formed in said first region of the substrate;
a second region of said semiconductor substrate where a pair of complementarily connected second MOS transistors (7 ,9;55 ,57) are formed adjacent to said first region, one (9; 55) of said second MOS transistors being of the second conductivity type and the other (7; 57) of said second MOS transistors being of the first conductivity type and formed in a second well of the second conductivity type in said substrate, said second MOS transistors (7, 9; 55, 57) having gate, source and drain regions (25, 29, 27, 33, 35, 37; 73, 77, 75; 81, 83, 85);
a second power source for said second MOS transistors being arranged to provide a second potential difference between a second potential (Vpp) and ground potential by providing said second potential to said source (29; 83) of the one of said second MOS transistors of the first conductivity type as well as to a second well contact region (31; 87) formed in said second well, and by providing said ground potential to said source (35; 77) of the one of said second MOS transistors of the second conductivity type as well as to a second substrate contact region (39; 79) formed in said second region of the substrate, said second potential being different from said first potential;
the gate, source and drain regions of the first and second MOS transistors as well as the well contact and substrate contact regions being arranged in a row extending in said first and second regions and across said boundary formed between said first and second regions of the semiconductor substrate;
wherein the two MOS transistors (5, 7; 53, 55) adjacent to each other in said row on respective sides of the boundary between said first and second regions of the semiconductor substrate have the same channel polarity; and
wherein said boundary is located in said semiconductor substrate of the first conductivity type, and wherein the sequence of doping types of the source, drain, well and intervening regions from said boundary along said row in said first region is the same as the sequence of doping types of the source, drain, well and intervening regions from said boundary along said row in said second region.

2. A semiconductor circuit according to claim 1, wherein the MOS transistors (53, 55) of said first and second regions disposed adjacent to each other on respective sides of the boundary are each of N-channel type.

3. A semiconductor circuit according to claim 1, wherein the MOS transistors (5, 7) of said first and second regions disposed adjacent to each other on respective sides of the boundary are each of P-channel type.

## Patentansprüche

1. Halbleiterschaltung, welche innerhalb eines Halbleitersubstrates (1) eines ersten Leitfähigkeitstyps (P) gebildet ist, und umfasst:
eine erste Region des Halbleitersubstrates, in welcher ein Paar komplementär verbundener erster MOS-Transistoren (5, 5; 51, 53) gebildet ist, wobei einer (3; 53) der ersten MOS-Transistoren von einem zweiten Leitfähigkeitstyp (N) ist, und der andere (5; 51) der ersten MOS-Transistoren vom ersten Leitfähigkeitstyp ist und in einer ersten Wanne des zweiten Leitfähigkeitstyps in dem Substrat gebildet ist, und die ersten MOS-Transistoren (3, 5; 51, 53) Gate-, Source- und Drain-Gebiete (11, 15, 13; 19, 21, 23; 57, 61, 59; 65, 67, 69) haben;
eine erste Quelle für die ersten MOS-Transistoren, welche angeordnet ist, eine erste Potentialdifferenz zwischen einem ersten Potential (Vdd) und dem Erdpotential bereitzustellen, durch Bereitstellung des ersten Potentials für das Source (21; 61) des ersten MOS-Transistors des ersten Leitfähigkeitstyps und für ein erstes Wannenkontaktgebiet (25; 63), welches in der ersten Wanne gebildet ist, und durch Bereitstellung des Erdpotentials für das Source (15; 77) des ersten MOS-Transistors des zweiten Leitfähigkeitstyps und für ein erstes Substratkontaktgebiet (17; 71), das in dem ersten Gebiet des Substrats gebildet ist;
ein zweites Gebiet des Halbleitersubstrates, in welchem ein Paar von komplementär verbundenen zweiten MOS-Transistoren (7, 9; 55, 57) neben dem ersten Gebiet gebildet ist, wobei einer (9; 55) der zweiten MOS-Transistoren vom zweiten Leitfähigkeitstyp ist und der andere (7,; 57) der zweiten MOS-Transistoren vom ersten Leitfähigkeitstyp ist und in einer zweiten Wanne des zweiten Leitfähigkeitstyps in dem Substrat gebildet ist, die zweiten MOS-Transistoren (7, 9; 55, 57) Gate-, Source- und Drain-Gebiete (25, 29, 27; 33, 35, 37; 73, 77, 75; 81, 82, 83, 85) haben;
eine zweite Quelle für die zweiten MOS-Transistoren, welche angeordnet ist, eine zweite Potentialdifferenz zwischen einem zweiten Potential (Vpp) und dem Erdpotential bereitzustellen, durch Bereitstellung des zweiten Potentials für das Source (29; 83) des zweiten MOS-Transistors des ersten Leitfähigkeitstyps und für ein zweites Wannenkontaktgebiet (31, 87), welches in der zweiten Wanne gebildet ist, und durch Bereitstellung des Erdpotentials für das Source (35; 77) des zweiten MOS-Transistors des zweiten Leitfähigkeitstyps und für ein zweites Substratkontaktgebiet (39; 79), welches in dem zweiten Gebiet des Substrats gebildet ist, wobei das zweite Potential verschieden ist von dem ersten Potential;
wobei die Gate-, Source- und Drain-Gebiete der ersten und zweiten MOS-Transistoren, und die Wannenkontakt- und Substratkontakt-Gebiete in einer Reihe, welche sich in die ersten und zweiten Regionen und über die zwischen den ersten und zweiten Regionen gebildete Grenze erstreckt, des Halbleitersubstrats angeordnet sind;
wobei die zwei MOS-Transistoren (5, 7; 53, 55), welche in der Reihe auf jeweiligen Seiten der Grenze zwischen den ersten und zweiten Gebieten des Halbleitersubstrates nebeneinanderliegen, die gleiche Kanalpolarität haben; und
wobei die Grenze sich in dem Halbleitersubstrat des ersten Leitfähigkeitstyps befindet, und wobei die Sequenz von Dotierarten der Source-, Drain-, Wannen- und Zwischen-Gebiete von der Grenze entlang der Reihe in dem ersten Gebiet gleich ist wie die Sequenz der Dotierarten der Source-, Drain-, Wannen- und Zwischengebiete von der Grenze entlang der Reihe in dem zweiten Gebiet.

2. Halbleiterschaltung nach Anspruch 1, wobei die MOS-Transistoren (53, 55) der ersten und zweiten Gebiete, welche auf jeweiligen Seiten der Grenze nebeneinander angeordnet sind, jeweils vom N-Kanal-Typ sind.

3. Halbleiterschaltung nach Anspruch 1, wobei die MOS-Transistoren (5, 7) der ersten und zweiten Gebiete, welche auf jeweiligen Seiten der Grenze nebeneinander angeordnet sind jeweils vom P-Kanal-Typ sind.

## Revendications

1. Circuit à semi-conducteur formé dans un substrat (1) semi-conducteur d'un premier type de conductivité (P) et comprenant :
une première région dudit substrat semi-conducteur dans laquelle sont formés une paire de premiers transistors MOS (3, 5 ; 51, 53) connectés de façon complémentaire, l'un (3 ; 53) desdits premiers transistors MOS étant d'un second type de conductivité (N) et l'autre (5 ; 51) desdits premiers transistors MOS étant du premier type de conductivité et étant formé dans un premier puits du second type de conductivité dans ledit substrat, lesdits premiers transistors MOS (3, 5 ; 51, 53) ayant des régions de grille, de source et de drain (11, 15, 13 ; 19, 21, 23 ; 57, 61, 59 ; 65, 67, 69) ;
une première source d'alimentation pour lesdits premiers transistors MOS étant conçue pour fournir une première différence de potentiel entre un premier potentiel (Vdd) et un potentiel de masse en fournissant ledit premier potentiel à ladite source (21 ; 61) de l'un desdits premiers transistors MOS du premier type de conductivité ainsi qu'à une première région (25 ; 63) de contact de puits formée dans ledit premier puits, et en fournissant ledit potentiel de masse à ladite source (15 ; 67) de l'un desdits premiers transistors MOS du second type de conductivité ainsi qu'à une première région (17 ; 71) de contact de substrat formée dans ladite première région du substrat ;
une seconde région dudit substrat semi-conducteur dans laquelle une paire de seconds transistors MOS (7, 9 ; 55, 57) connectés de façon complémentaire sont formés de façon adjacente à ladite première région, l'un (9 ; 55) desdits seconds transistors MOS étant du second type de conductivité et l'autre (7 ; 57) desdits seconds transistors MOS étant du premier type de conductivité et étant formé dans un second puits du second type de conductivité dans ledit substrat, lesdits seconds transistors MOS (7, 9 ; 55, 57) ayant des régions de grille, de source et de drain (25, 29, 27 ; 33, 35, 37 ; 73, 77, 75 ; 81, 83, 85) ;
une seconde source d'alimentation pour lesdits seconds transistors MOS conçue pour fournir une seconde différence de potentiel entre un second potentiel (Vpp) et un potentiel de masse en fournissant ledit second potentiel à ladite source (29 ; 83) de l'un desdits seconds transistors MOS du premier type de conductivité ainsi qu'à une seconde région (31 ; 87) de contact de puits formée dans ledit second puits, et en fournissant ledit potentiel de masse à ladite source (35 ; 77) de l'un desdits seconds transistors MOS du second type de conductivité ainsi qu'à une seconde région (39 ; 79) de contact de substrat formée dans ladite seconde région du substrat, ledit second potentiel étant différent dudit premier potentiel ;
les régions de grille, de source et de drain des premierS et secondS transistors MOS ainsi que les régions de contact de puits et de contact de substrat étant agencées suivant une rangée s'étendant dans lesdites première et seconde régions et à travers ladite frontière formée entre lesdites première et seconde régions du substrat semi-conducteur ;
dans lequel les deux transistors MOS (5, 7 ; 53, 55) qui sont adjacents l'un à l'autre dans ladite rangée sur des côtés respectifs de la frontière entre lesdites première et seconde régions du substrat semi-conducteur ont la même polarité de canal ; et
dans lequel ladite frontière est située dans ledit substrat semi-conducteur du premier type de conductivité, et dans lequel la séquence de types de dopage des régions de source, de drain, de puits et intermédiaire en partant de ladite frontière le long de ladite rangée dans ladite première région, est identique à la séquence de types de dopage des régions de source, de drain, de puits et intermédiaire en partant de ladite frontière le long de ladite rangée dans ladite seconde région.

2. Circuit à semi-conducteur selon la revendication 1, dans lequel les transistors MOS (53, 55) desdites première et seconde régions disposées de façon adjacente les unes aux autres sur des côtés respectifs de la frontière sont chacun du type à canal N.

3. Circuit à semi-conducteur selon la revendication 1, dans lequel les transistors MOS (5, 7) desdites première et seconde régions disposées de façon adjacente les unes aux autres sur des côtés respectifs de la frontière sont chacun du type à canal P.
